Europäisches Patentamt

European Patent Office

Office européen des brevets

(19)

(11) Veröffentlichungsnummer: **0 310 796**
**A1**

(12) ## EUROPÄISCHE PATENTANMELDUNG

(21) Anmeldenummer: **88113547.9**

(22) Anmeldetag: **20.08.88**

(51) Int. Cl.⁴: **H03D 3/00**

(30) Priorität: **08.10.87 CH 3940/87**

(43) Veröffentlichungstag der Anmeldung:
**12.04.89 Patentblatt 89/15**

(84) Benannte Vertragsstaaten:
**AT CH DE FR GB IT LI NL SE**

(71) Anmelder: **BBC Brown Boveri**
**Aktiengesellschaft**

**CH-5401 Baden(CH)**

(72) Erfinder: **Braun, Walter, Dr.**
**Winzerstrasse 40**
**CH-5430 Wettingen(CH)**

(54) **Verfahren zur Demodulation eines FM-Signals.**

(57) Ein Verfahren zur Demodulation eines FM-Signals (FM = Frequenz Modulation), bei welchem das FM-Signal direkt in eine Inphasen-und eine Quadraturkomponente eines komplexen Frequenzbasisbandes heruntergemischt wird und aus einer Phasenlage des komplexen Frequenzbasisbandsignals ein Modulationssignal bestimmt wird, ermittelt die Phasenlage aus einer Kurvenlänge des Frequenzbasisbandsignals. Die Kurvenlänge wird durch eine Länge eines Polygonzuges angenähert, welcher durch aufeinanderfolgende abgetastete Werte des komplexen Frequenzbasisbandsignals aufgespannt wird. Bevorzugterweise wird ein geschätzter Radius einer Hüllkurve des komplexen Frequenzbasisbandes benützt, um die Kurvenlänge zu normieren.

Ein erfindungsgemässer Signalempfänger umfasst einen Direktkonverter (2), ac-gekoppelte Verstärker (5a, 5b), einen Demodulator (6a) und einen Lautsprecher (8).

Fig.1a

# VERFAHREN ZUR DEMODULATION EINES FM-SIGNALS

## TECHNISCHES GEBIET

Die Erfindung betrifft ein Verfahren zur Demodulation eines Fm-Signals (FM = Frequenz Modulation), wobei das FM-Signal direkt in eine Inphasen- und eine Quadraturkomponente eines komplexen Frequenzbasisbandsignals heruntergemischt wird und aus einer Phasenlage des komplexen Frequenzbasisbandsignals ein Modulationssignal bestimmt wird.

## STAND DER TECHNIK

Mit zunehmender Verbreitung von Mobilfunkgeräten steigen auch die Anforderungen an deren Komfort. Solche Geräte sollen nicht nur gute Empfangseigenschaften besitzen, sondern auch klein, leicht und handlich sein. Es ist deshalb wichtig, dass zur Demodulation von FM-Signalen von der Technik der hochintegrierten Schaltungen vorteilhaft Gebrauch gemacht werden kann. Es hat sich nun gezeigt, dass sich für diese sogenannte Integration am besten Signalempfänger eignen, die nach dem Prinzip der Direktkonversion arbeiten. D.h., ein FM-Signal wird von einer Trägerfrequenz in das Frequenzbasisband heruntergemischt, ohne irgendwelche Zwischenfrequenzstufen zu benützen.

Ein auf diese Weise erhaltenes Frequenzbasisbandsignal muss zur Weiterverarbeitung jedoch meistens noch verstärkt werden. Um Offsetprobleme zu vermeiden, ist es üblich, ac-gekoppelte Verstärker zu verwenden.

In der Druckschrift "A radio-paging receiver architecture and Demodulator" von C.B. Marshall, Philips Journal of Research, Vol. 41, Supplement No. 2, 1986, ist ein Signalempfänger zur Demodulation von digitalen Daten offenbart, welcher nach dem Prinzip der Direktkonversion arbeitet. Will man einen solchen Signalempfänger zur Demodulation von FM-Signalen verwenden, so treten Signalverzerrungen auf, die hauptsächlich vom ac-gekoppelten Verstärker herrühren. Im Gegensatz zu digitalen Signalen, haben analoge Signale nicht zu vernachlässigende Gleichstromkomponenten. Dadurch, dass diese durch einen ac-gekoppelten Verstärker unterdrückt werden, kommt es z.B. nach Sprechpausen zu beträchtlichen Signalverzerrungen.

## DARSTELLUNG DER ERFINDUNG

Die Aufgabe der Erfindung besteht darin, ein Verfahren zur Demodulation eines FM-Signals anzugeben, wobei das FM-Signal direkt in eine Inphasen- und eine Quadraturkomponente eines komplexen Frequenzbasisbandsignals heruntergemischt wird und aus einer Phasenlage des komplexen Frequenzbasisbandsignals ein Modulationssignal bestimmt wird, welches Verfahren eine Verzerrung des Frequenzbasisbandsignals aufgrund einer Dämpfung von dessen Gleichstromkomponente kompensiert.

Erfindungsgemäss besteht die Lösung darin, dass die Phasenlage aus einer Kurvenlänge des Frequenzbasisbandsignals ermittelt wird.

In einer bevorzugten Ausführungsform der Erfindung wird zusätzlich ein geschätzter Radius einer Hüllkurve des komplexen Frequenzbasisbandsignals bestimmt, welcher für eine Normierung der Kurvenlänge herangezogen wird. Auf diese Weise lässt sich eine Regelung eines Leistungspegels des Modulationssignals in einem Demodulator integrieren.

Weitere bevorzugte Ausführungsformen der Erfindung ergeben sich aus den Unteransprüchen.

## KURZE BESCHREIBUNG DER ZEICHNUNGEN

Nachfolgend soll die Erfindung anhand von Ausführungsbeispielen im Zusammenhang mit der Zeichnung näher erläutert werden.
Es zeigen:

2

Fig. 1A Blockschaltbild eines Signalempfängers,

Fig. 1B Blockschaltbild eines Demodulators mit einer integrierten Regelung eines Leistungspegels,

Fig. 2 Darstellung eines komplexen Frequenzbasisbandsignals,

Fig. 3 Blockschaltbild eines Direktkonverters,

Fig. 4 Blockschaltbild eines Signalempfängers mit einer separaten Regelung eines Leistungspegels,

Fig. 4B Blockschaltbild eines Demodulators ohne Regelung des Leistungspegels,

Fig. 5A eine Darstellung eines nach einem erfindungsgemässen Verfahren erzeugten Modulationssignals und

Fig. 5B eine Darstellung eines nach einem bekannten Verfahren erzeugten Modulationssignals.


## WEGE ZUR AUSFÜHRUNG DER ERFINDUNG


In einem ersten Ausführungsbeispiel wird ein Signalempfänger beschrieben, bei welchem eine Regelung eines Leistungspegels eines Modulationssignals in einem Demodulator integriert ist.

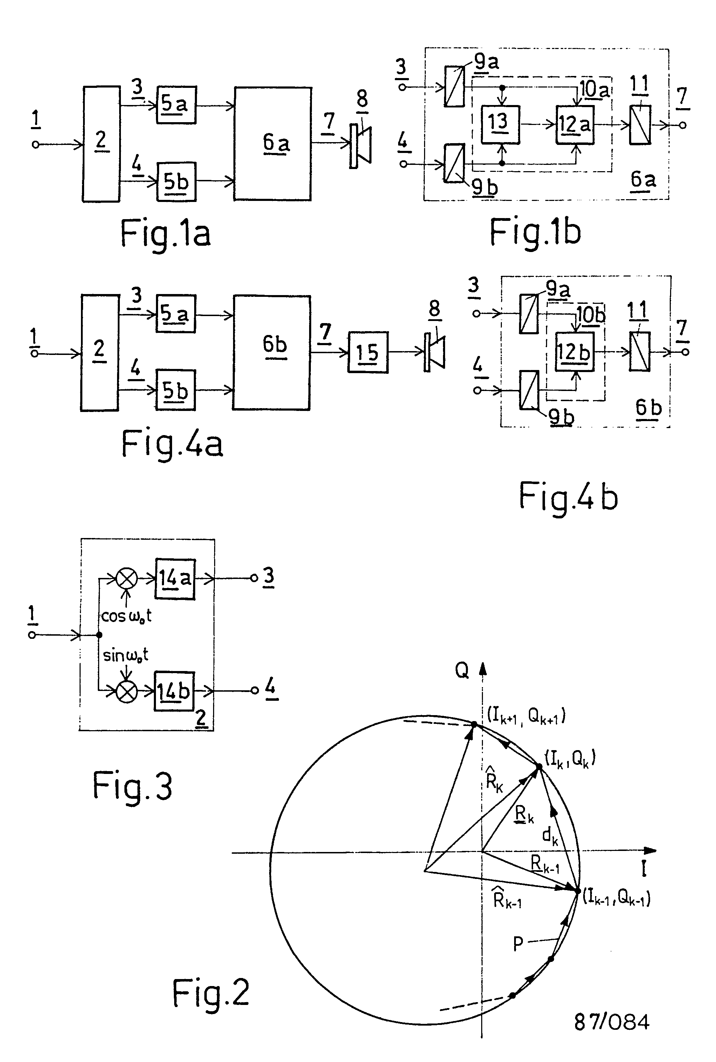

Fig. 1A zeigt ein Blockschaltbild eines Signalempfängers, welcher nach dem erfindungsgemässen Verfahren arbeitet. Ein FM-Signal 1 von z.B. wenigen 100 MHz wird einem Direktkonverter 2 zugeführt. Dieser mischt das FM-Signal 1 direkt in ein Frequenzbasisband herunter. Es entsteht ein komplexes Frequenzbasisbandsignal, welches vom Direktkonverter 2 in der Form einer Inphasenkomponente 3 und einer Quadraturkomponente 4 ausgegeben wird. Inphasen- und Quadraturkomponente 3, 4 werden von ac-gekoppelten Verstärkern 5a, 5b verstärkt und an einen Demodulator 6a weitergeleitet. Der Demodulator 6a erzeugt ein analoges Modulationssignal 7, welches in einem Lautsprecher 8 höhrbar gemacht wird.

Fig. 1B zeigt ein Blockschaltbild des Demodulators 6a. Inphasen-und Quadraturkomponente 3, 4 des komplexen Frequenzbasisbandsignals werden in A/D-Wandlern 9a, 9b mit einer gegebenen Abtastfrequenz abgetastet und digitalisiert. In einer Rechenschaltung 10a sind ein Phasenschätzalgorithmus 12a und ein Amplitudenschätzalgorithmus 13 implementiert. Der Phasenschätzalgorithmus 12a bestimmt eine Phasenlage des komplexen Frequenzbasisbandsignals und liefert an einem Ausgang eine digitalisierte Form des Modulationssignals 7, welche mit einem D/A-Wandler 11 in das analoge Modulationssignal 7 umgewandelt wird.

Der Kern der Erfindung liegt im Verfahren aus einer digitalen Form der Inphasen- und Quadraturkomponente des komplexen Frequenzbasisbandsignals die digitalisierte Form des Modulationssignals 7 zu gewinnen. Das Prinzip dieses Verfahrens soll anhand einer graphischen Darstellung erklärt werden.

Fig. 2 zeigt eine graphische Darstellung des komplexen Frequenzbasisbandsignals wie es am Demodulator 6a anliegt. Auf der Abszisse ist die Inphasenkomponente 3 und auf der Ordinate die Quadraturkomponente 4 aufgetragen. Ein komplexes Frequenzbasisbandsignal wird so als eine Kurve in einer Ebene dargestellt. Jedem Punkt der Kurve kann ein Phasenvektor zugeordnet werden, welcher im Ursprung dieser Darstellung beginnt und im betreffenden Punkt endet. In einem Idealfall hat das Frequenzbasisbandsignal als Hüllkurve einen Kreis mit einem Mittelpunkt im Ursprung und einem konstanten Radius. In diesem Fall ergibt sich die Phasenlage aus der Richtung des Phasenvektors, d.h. in bekannter Weise als arctan (I/Q) mit I = Inphasenkomponente und Q = Quadraturkomponente. Wird nun das Frequenzbasisbandsignal z.B. mit einem ac-gekoppelten Verstärker verstärkt, so beginnt der Mittelpunkt der Hüllkurve herumzuwandern, da Gleichstromkomponenten des Frequenzbasisbandsignals gedämpft worden sind. Die Art der Bewegung des Mittelpunkts wird wesentlich bestimmt durch eine Grenzfrequenz der Verstärker 5a, 5b. Diese Grenzfrequenz liegt typischerweise bei etwa 10 Hz. Im Vergleich dazu sind die Frequenzen eines Sprachsignals, welche üblicherweise zwischen 300 und 3000 Hz liegen, hoch, so dass sich der Mittelpunkt der Hüllkurve, wenn er einmal z.B. aufgrund einer Sprechpause, aus dem Ursprung weggewandert ist, vergleichsweise langsam bewegt. Eine Bestimmung der Phasenlage des Frequenzbasisbandsignals aufgrund der Richtung des Phasenvektors führt somit zu erheblichen Verzerrungen.

Das Prinzip der Erfindung liegt nun darin, die Phasenlage nicht aufgrund der Richtung des Phasenvektors, sondern aufgrund der Kurvenlänge des Frequenzbasisbandsignals zu bestimmen.

Durch das Abtasten erhält man einen Polygonzug P, welcher durch aufeinanderfolgende, abgetastete Werte des komplexen Frequenzbasisbandsignals aufgespannt wird. Der Polygonzug P dient als eine Näherung des komplexen Frequenzbasisbandsignals. Ein Zuwachs $d_k$ der Kurvenlänge des Frequenzbasisbandsignals ergibt sich somit aus Betrag und Vorzeichen wie folgt:

Ein Betrag des Zuwachses $d_k$ ist bestimmt durch einen euklidischen Abstand zwischen einem neuen, abgetasteten Wert $(I_k, Q_k)$ und einem benachbarten, vorhergehenden abgetasteten Wert $(I_{k-1}, Q_{k-1})$, d.h.

$$d_k = \sqrt{(I_k - I_{k-1})^2 + (Q_k - Q_{k-1})^2} \qquad (I)$$

und ein Vorzeichen des Zuwachses $d_k$ ist gegeben durch ein Vorzeichen eines Vektorproduktes (dargestellt durch das Zeichen "x") von zugeordneten Phasenvektoren $\underline{R}_k$ und $\underline{R}_{k-1}$, d.h.

$$\text{sign}(d_k) = \text{sign } (\underline{R}_{k-1} \times \underline{R}_k) \qquad (II)$$

$$\text{sign}(x) = \begin{cases} 1 & \text{für } x > 0 \\ 0 & \text{für } x = 0 \\ -1 & \text{für } x < 0 \end{cases} \qquad (III)$$

Die Rechenschaltung 10a führt gleichzeitig mit der Demodulation des komplexen Frequenzbasisbandsignals eine Regelung des Leistungspegels des Modulationssignals 7 aus. Zu diesem Zweck ermittelt der Amplitudenschätzalgorithmus 13 einen geschätzten Radius $\hat{R}_k$ der Hüllkurve des komplexen Frequenzbasisbandsignals. Ein digitaler Wert $s_k$ des Modulationssignals 7 ergibt sich durch eine Normierung des Zuwachses $d_k$ mit dem geschätzten Radius $\hat{R}_k$:

$$s_k = d_k / \hat{R}_k \qquad (IV)$$

Bevorzugterweise wird zudem der Zuwachs $d_k$ auf Null gesetzt, wenn der geschätzte Radius $\hat{R}_k$ unter einen, durch einen Rauschpegel des Signalempfängers gegebenen Schwellenwert $R_{min}$ fällt. Auf diese Weise ist in der Rechenschaltung 10a die Wirkung einer Squelchschaltung integriert.

Eine andere, bevorzugte Möglichkeit zur Begrenzung des Rauschens besteht darin, den Zuwachs $d_k$ mit einem gegebenen Schwellenwert $R_{min}$ zu normieren, wenn der geschätzte Radius $\hat{R}_k$ unter diesen Schwellenwert $R_{min}$ fällt. Damit lässt sich vermeiden, dass z.B. ein FM-Signal mit einer geringen Leistung ein lautes Rauschen des Lautsprechers zur Folge hat.

Der Amplitudenschätzalgorithmus 13 kann z.B. wie folgt realisiert werden. Für jeden abgetasteten Wert des komplexen Frequenzbasisbandsignals wird eine Länge $R_k$ des zugeordneten Phasenvektors $\underline{R}_k$ ermittelt:

$$R_k = |\underline{R}_k| = \sqrt{I_k^2 + Q_k^2} \qquad (V)$$

$$\left. \begin{array}{l} I_k = \text{Inphasenkomponente} \\ Q_k = \text{Quadraturkomponente} \end{array} \right\} \text{ zum Zeitpunkt } kT_o$$

Durch eine Glättung dieser Längen $R_k$ der Phasenvektoren wird ein geschätzter Radius $\hat{R}_k$ erzeugt. Die Glättung kann z.B. mit einem Tiefpassfilter erster Ordnung mit einer geeigneten Grenzfrequenz vorgenommen werden. Dies entspricht einer besonders einfachen Ausführungsform. Selbstverständlich können auch andere Methoden zur Glättung verwendet werden, solange die Rechenschaltung 10a eine entsprechend grosse Rechenkapazität besitzt.

Ein wesentlicher Parameter des Demodulators 6a resp. der A/D-Wandler 9a, 9b stellt die Abtastfrequenz dar. Wird diese zu klein gewählt, so wird die erfindungsgemässe Approximation der Kurvenlänge des Frequenzbasisbandsignals durch die Länge des Polygonzuges P schlecht. Aus dieser Ueberlegung heraus, sollte die Abtastfrequenz mindestens 5 mal so gross sein wie ein Frequenzhub des Frequenzbasisbandsignals. Da bei einer Uebertragung von Audiosignalen das Frequenzbasisbandsignal eine Bandbreite von typischerweise 5 kHz hat, sollte demzufolge die Abtastfrequenz mindestens etwa 25 kHz betragen.

Fig. 3 zeigt ein Blockschaltbild eines Direktkonverters 2. Das eintreffende FM-Signal 1 wird in zwei Signalpfade aufgetrennt. Im einen wird durch Multiplikation mit $\cos\omega_o t$ (wobei $\omega_o$ die Trägerfrequenz bezeichnet) und Filterung mit einem Tiefpassfilter 14a die Inphasenkomponente 3 und im anderen durch Multiplikation mit $\sin\omega_o t$ und Filterung mit einem Tiefpassfilter 14b die Quadraturkomponente 4 des komplexen Frequenzbasisbandsignals erzeugt. Die Einzelheiten eines solchen Direktkonverters 2 sind bekannt und können z.B. der eingangs genannten Druckschrift von C.B. Marshall entnommen werden.

In einem zweiten Ausführungsbeispiel soll ein Signalempfänger beschrieben werden, bei welchem eine Regelung des Leistungspegels des Modulationssignals ausserhalb des Demodulators erfolgt.

Fig. 4a zeigt ein Blockschaltbild eines solchen Signalempfängers. Er weist einen ähnlichen Aufbau wie der in Fig. 1 gezeigte Signalempfänger auf (weshalb der bessern Uebersicht wegen gleiche Teile mit gleichen Bezugszeichen versehen sind). Auf bereits beschriebene Teile wird an dieser Stelle nicht mehr besonders eingegangen.

Gegenüber dem ersten Ausführungsbeispiel (Fig. 1a) ist neu ein Pegelregler 15 hinzugekommen. Er regelt den Leistungspegel des vom Demodulator 6b kommenden Modulationssignal 7. Als Folge davon kann eine vereinfachte Rechenschaltung 10b eingesetzt werden. Diese umfasst nunmehr einen Phasenschätzalgorithmus 12b, welcher einen Zuwachs $d_k$ in der oben beschriebenen Weise ermittelt. Im Gegensatz zum ersten Ausführungsbeispiel wird der Zuwachs $d_k$ der Kurvenlänge nicht normiert. Ein digitaler Wert $s_k$ des Modulationssignals 7 entspricht dann unmittelbar dem Zuwachs $d_k$.

Dieses zweite Ausführungsbeispiel zeichnet sich somit durch eine besonders einfaché Rechenschaltung aus. Auf diese Weise können sich z.B. problemlos höhere Abtastfrequenzen realisieren lassen.

Um die vorteilhafte Wirkung der Erfindung zu verdeutlichen, wird nachfolgend das Resultat einer Simulation eines erfindungsgemässen Verfahrens mit denjenigen eines bekannten Verfahrens verglichen.

Der Aufbau eines erfindungsgemässen Signalempfängers kann z.B. wie im ersten Ausführungsbeispiel (Fig. 1A, Fig. 1B) gewählt werden. Die ac-gekoppelten Verstärker 5a, 5b haben dabei eine Grenzfrequenz von etwa 10 Hz. Die Abtastfrequenz der A/D-Wandler 9a, 9b beträgt 28 kHz. Der Amplitudenschätzalgorithmus 13 führt eine Glättung aus, welche eine Grenzfrequenz von etwa 140 Hz aufweist. Zur Verdeutlichung des Resultats wurde der Signalempfänger als rauschfrei angenommen. Das zu demodulierende, empfangende FM-Signal 1 übertrage einen Einheitsschritt. D.h. bei einem idealen Empfänger würde das Modulationssignal einen Sprung von 0 auf 1 ausführen.

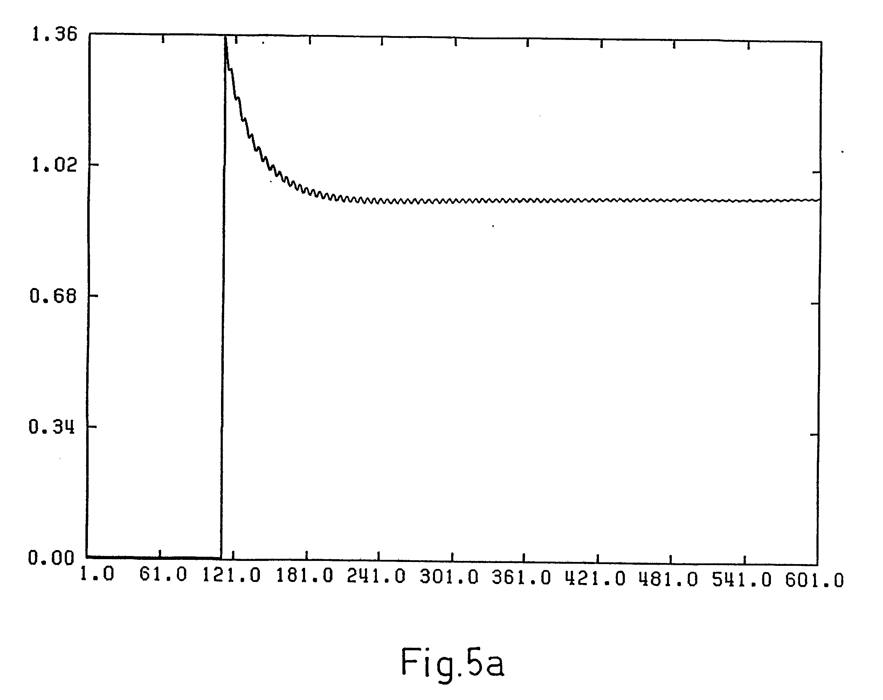

Fig. 5A zeigt eine Darstellung des Modulationssignals 7, welches aufgrund eines erfindungsgemäss demodulierten FM-Signals entsteht.

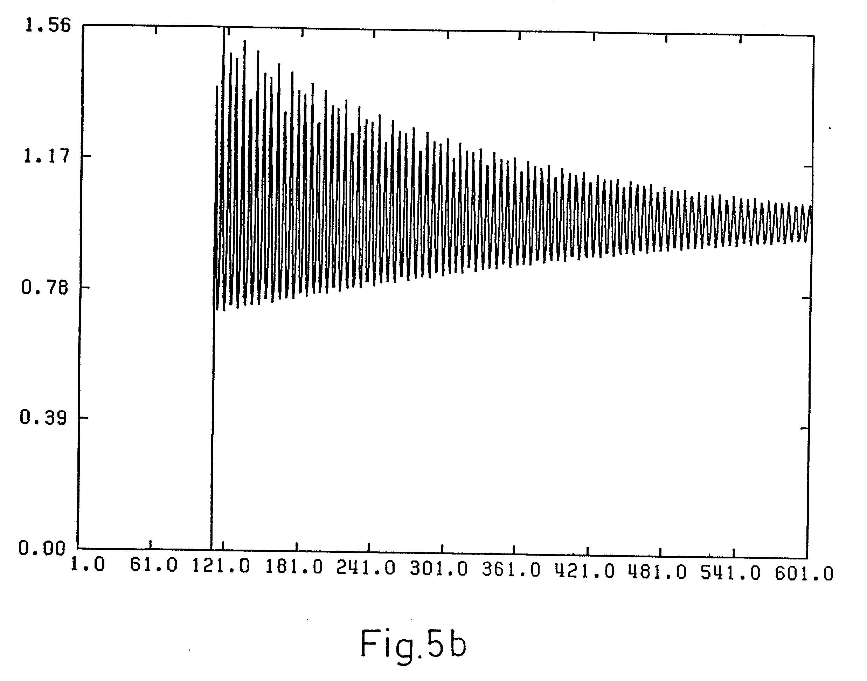

Fig. 5B zeigt als Vergleich dazu eine Darstellung eines Modulationssignals, wie es mit einem Demodulationsverfahren entsprechend dem Stand der Technik erzeugt wird.

Auf der Abszisse ist jeweils die Zeit in Einheiten eines Abtastintervalles $T(T = 1/28000$ sec $= 35.7$ msec) aufgetragen, auf der Ordinate eine normierte Amplitude des Modulationssignals. Das in Fig. 5B sichtbare, lang anhaltende Ueberschwingen des Modulationssignals, welches sich im Lautsprecher vor allem nach Sprechpausen als unangenehmes Geräusch bemerkbar macht, wird durch die Erfindung weitgehend vermieden (vgl. Fig. 5A).

Die Merkmale der Erfindung lassen sich in vielfältiger Weise zu vorteilhaften Ausführungsformen kombinieren. Allen Ausführungsformen ist gemein, dass sie Signalverzerrungen aufgrund gedämpfter Gleichstromkomponenten zu kompensieren vermögen. Die digitale Ausführung des Demodulators, dessen Anwendung sich keinesweg auf die Demodulation von Audiosignalen beschränkt, macht einen erfindungsgemässen Signalempfänger einer Integration weiterer Funktionen leicht zugänglich.

**Ansprüche**

1. Verfahren zur Demodulation eines FM-Signals (FM = Frequenz Modulation), wobei

a) das FM-Signal direkt in eine Inphasen- und eine Quadraturkomponente eines komplexen Frequenzbasisbandsignals heruntergemischt wird, und

b) aus einer Phasenlage des komplexen Frequenzbasisbandsignals ein Modulationssignal bestimmt wird, dadurch gekennzeichnet, dass

c) die Phasenlage aus einer Kurvenlänge des komplexen Frequenzbasisbandsignals ermittelt wird.

2. Verfahren nach Anspruch 1, dadurch gekennzeichnet, dass Inphasen- und Quadraturkomponente des komplexen Frequenzbasisbandsignals mit einem ac-gekoppelten Verstärker verstärkt werden.

3. Verfahren nach Anspruch 2, dadurch gekennzeichnet, dass die Kurvenlänge durch eine Länge eines Polygonzuges angenähert wird, welcher durch aufeinanderfolgende, abgetastete Werte des komplexen Frequenzbasisbandsignals aufgespannt wird, wobei eine Abtastfrequenz verwendet wird, die mindestens fünfmal so gross ist wie ein Frequenzhub des Frequenzbasisbandsignals.

4. Verfahren nach Anspruch 3, dadurch gekennzeichnet, dass zu jedem neuen abgetasteten Wert des komplexen Frequenzbasisbandsignals ein Zuwachs der Kurvenlänge gegenüber einem benachbarten, vorhergehenden abgetasteten Wert bestimmt wird, wobei ein Betrag des Zuwachses durch einen euklidi-

5

schen Abstand zwischen neuem und benachbartem vorhergehenden, abgetasteten Wert gegeben ist und ein Vorzeichen des Zuwachses durch ein Vorzeichen eines Vektorproduktes von zugeordneten Phasenvektoren.

5. Verfahren nach Anspruch 4, dadurch gekennzeichnet, dass ein geschätzter Radius einer Hüllkurve des komplexen Frequenzbasisbandsignals bestimmt wird.

6. Verfahren nach Anspruch 5, dadurch gekennzeichnet, dass der Zuwachs der Kurvenlänge mit dem geschätzten Radius normiert wird.

7. Verfahren nach Anspruch 6, dadurch gekennzeichnet, dass der Zuwachs der Kurvenlänge auf Null gesetzt wird, wenn der geschätzte Radius unter einen gegebenen Schwellenwert fällt.

8. Verfahren nach Anspruch 6, dadurch gekennzeichnet, dass der Zuwachs der Kurvenlänge mit einem gegebenen Schwellenwert normiert wird, wenn der geschätzte Radius unter diesen Schwellenwert fällt.

9. Verfahren nach Anspruch 5, dadurch gekennzeichnet, dass ein Leistungspegel des Modulationssignals geregelt wird.

10. Verfahren nach Anspruch 5, dadurch gekennzeichnet, dass der geschätzte Radius auf die Weise bestimmt wird, dass zu jedem abgetasteten Wert des komplexen Frequenzbasisbandsignals eine Länge des zugeordneten Phasenvektors ermittelt wird, und dass sich der geschätzte Radius aus einer Tiefpassfilterung der ermittelten Längen ergibt.

Fig.1a

Fig.1b

Fig.4a

Fig.4b

Fig.3

Fig.2

87/084

Fig.5a

EP 0 310 796 A1

87/084

Fig.5b

EP 0 310 796 A1

Europäisches
Patentamt

**EUROPÄISCHER RECHERCHENBERICHT**

Nummer der Anmeldung

EP 88 11 3547

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 143 539 (STC PLC) <br> * Seite 2, Zeile 7 - Seite 5, Zeile 16; Figuren 1,2,9 * <br> --- | 1 | H 03 D 3/00 |
| A | EP-A-0 080 157 (SIEMENS) <br> * Zusammenfassung; Figuren 2,3 * <br> --- | 1 | |
| A,D | PHILIPS JOURNAL OF RESEARCH, Band 41, Zusatz, Nr. 2, 1986, Seiten 1-128, Eindhoven, NL; C.B. MARSHALL: "A radio-paging receiver architecture and demodulator" <br> * Kapitel 1, Appendix A; Seiten 1-6; Seiten 113-118 * <br> ----- | 1 | |

**RECHERCHIERTE SACHGEBIETE (Int. Cl.4)**

H 03 D
H 04 H

Der vorliegende Recherchenbericht wurde für alle Patentansprüche erstellt

| Recherchenort | Abschlußdatum der Recherche | Prüfer |
|---|---|---|
| DEN HAAG | 12-01-1989 | DHONDT I.E.E. |